# EUROPEAN PATENT APPLICATION

(11) **EP 0 993 034 A2**
(43) Date of publication of application: **12.04.2000**
(21) Application number: 99307383.2
(22) Date of filing: 17.09.1999
(51) Int. Cl.: H01L 21/60, H01L 21/603

(54) **Method for bonding bumped electronic components to a substrate**

(30) Priority: 28.09.1998 US 161578
(71) Applicant: Ford Motor Company, Dearborn, MI 48126 (US)
(72) Inventor: Nuno, Rose Lynda, Detroit, Michigan 48209 (US); Pham, Cuong Van, Belleville, Michigan 48111 (US); Todd, Michael George, Anaheim Hills, California 92807 (US)
(74) Representative: Messulam, Alec Moses

(57) **Abstract**

There is disclosed herein a method for bonding an electronic component 10 having bump terminations 14 on a surface thereof to a dielectric substrate 20 having a plurality of copper mounting pads 22, comprising the steps of: (a) providing the component 10 and the substrate 20; (b) depositing a layer of silver 30 atop each copper mounting pad 22, thereby forming a plurality of silvered pads 40; (c) positioning the component atop the substrate such that each bump termination 14 is registered atop a respective one of the silvered pads 40; and (d) bonding the bump terminations to their respective silvered pads by solid-to-solid diffusion bonding, such as by thermocompression bonding.

## Description

The present invention relates generally to electronic components, and more particularly to a method for bonding bumped electronic components to a circuit board.

Electronic components may be attached to circuit boards using a variety of processes, such as wave soldering, reflow soldering, wirebonding, thermocompression bonding, conductive adhesive bonding, and the like. For some components, such as bare silicon integrated circuit (IC) dice or certain plastic- or ceramic-packaged components, the preferred method of bonding to a substrate is thermocompression. Thermocompression works by placing two metallic surfaces in intimate contact with each other and applying sufficient heat and pressure thereto for a time long enough to effect a solid-to-solid diffusion between the two metallic surfaces.

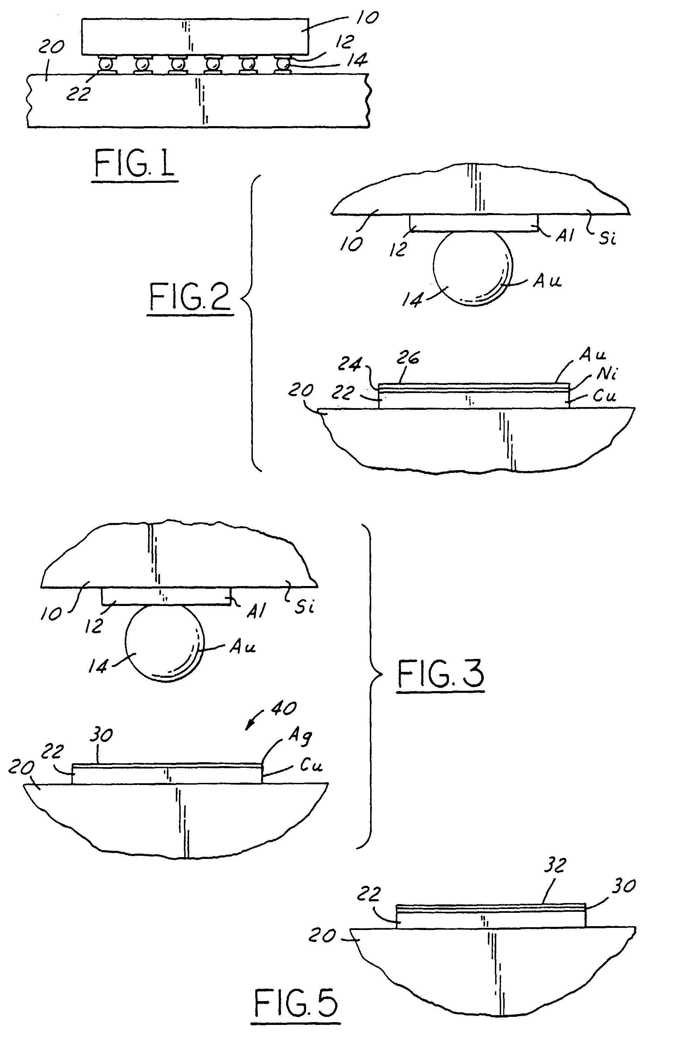

FIGS. 1 and 2 illustrate a conventional bare die 10 being thermocompression bonded to a substrate 20 (e.g., a typical FR-4 epoxy/glass laminate) with copper circuit traces and mounting pads 22 thereon. The component 10 has a plurality of metallic bond pads 12 that are formed thereon, and attached to each bond pad 12 is a bump termination 14 which is typically either solid gold or gold-plated.

The component 10 is thermocompression bonded to the substrate 20 by placing the component on the substrate "face down" such that each bump termination 14 is registered atop a respective mounting pad 22, and applying heat and pressure thereto to cause the desired solid-to-solid diffusion bonding between each bump 14 and pad 22. However, the gold bumps cannot be thermocompression bonded directly to the copper pads because of oxides that form on exposed copper surfaces. In reflow soldering applications, the exposed copper pads are covered with a protective layer of tin/lead solder by a process known as hot air solder levelling (HASL), but using this type of protective layer for thermocompression applications is not an option because (1) gold or other bumps cannot be successfully thermocompression bonded to tin/lead solder and (2) the planarity needed for successful thermocompression bonding cannot be provided by tin/lead HASL processing. Instead, the typical approach is to plate a barrier layer of nickel 24 (generally about 100 microinches in thickness) atop each copper pad 22, and to then plate a bonding layer of gold 26 (about 30 microinches thick) atop the nickel layer, as illustrated in FIG. 2. This provides an outer gold layer 26 to which the gold bump 14 may be thermocompression bonded.

However, using gold as the mounting pad outer bonding layer 26 is expensive, as is using a bi-layer nickel/gold plate-up of the copper pads 22. It would be desirable, therefore, to provide a way of eliminating the need to use gold as the outer pad layer 26, and even more desirable if such an approach could use a single layer rather than the conventional two-layer nickel/gold approach.

The present invention provides a method for thermocompression bonding bumped components to a substrate which avoids the use of a gold outer layer and a two-layer nickel/gold plate-up. The method comprises the steps of: (a) providing the component and the substrate; (b) depositing a layer of silver atop each copper substrate mounting pad, thereby forming a plurality of silvered pads; (c) positioning the component atop the substrate such that each bump termination is registered atop a respective one of the silvered pads; and (d) bonding the bump terminations to their respective silvered pads by solid-to-solid diffusion bonding, such as by thermocompression.

It is an advantage that the present invention avoids the use of gold as an outer bonding layer on copper mounting pads for bonding bumped components to a substrate.

Another advantage is that the present invention avoids the conventional two-layer nickel/gold approach by utilising a single, thin silver layer instead.

Yet another advantage is that the method of the present invention is quicker, easier, and less expensive than conventional prior art approaches.

The invention will now be described, by way of example, with reference to the accompanying drawings, in which:
FIG. 1 is a side view of a bumped electronic component bonded to a substrate according to the prior art;
FIG. 2 is an enlarged view of a portion of FIG. 1 showing a bump termination and corresponding mounting pad just prior to bonding;
FIG. 3 is an enlarged view of a portion of a bumped component and mounting pad/substrate just prior to bonding according to the present invention;
FIGS. 4A-B are process flow diagrams for bonding a bumped component to a substrate according to the prior art and the present invention, respectively; and
FIG. 5. is an enlarged view of a silvered mounting pad having an optional antioxidant coating thereon according to the present invention.

Referring now to the drawings, FIG. 3 shows an enlarged view of a bumped component 10 and substrate 20 just prior to being bonded according to the present invention. The component 10 may be a silicon-based bare die or a plastic-or ceramic-packaged device/carrier having metallic bond pads 12 thereon. An example of such a component is a gold-bumped bare silicon die, although many other types of bumped components may be bonded using the present invention. The bond pads 12 are typically made of aluminium, but may also be copper, nickel, titanium/ tungsten, or other suitable metals. The substrate 20 may be a conventional FR-4 board or any other substrate compatible with the type of diffusion bonding used; for example, the substrate may be a moulded plastic part which has copper mounting pads 22 applied thereto by plating, embossing, or other means.

To assist the reader in understanding the present invention, all reference numbers used herein are summarised in the table below, along with the elements they represent:
10 = Electronic component
12 = Metallic bond pads on component
14 = Bump terminations
20 = Substrate
22 = Copper mounting pads on substrate
24 = Nickel barrier layer
26 = Gold bonding layer
30 = Silver bonding layer
32 = Antioxidant layer
40 = Silvered pad
Ag = Silver
Al = Aluminium
Au = Gold
Cu = Copper
Ni = Nickel
Pd = Palladium
Pt = Platinum
Si = Silicon

The bumps 14 may be made from a single metal, or may be made having a central core of a first metal with an outer layer thereon of a second metal. In the former case, it is preferred that the single metal be a noble metal (e.g., gold, silver, palladium, platinum), while in the latter case it is preferred that the core/first metal be either a noble metal or a harder metal (e.g., copper, nickel) and that the outer layer/second metal be a noble metal. In either case, at least the outside surface of the bump should be a noble metal. As examples, the bumps 14 may be: (1) solid gold, (2) solid silver, (3) solid palladium, (4) solid platinum, (5) copper or nickel in core with an outer layer of gold, silver, palladium, or platinum, or (6) a first noble metal in core with an outer layer of a second, different noble metal, with (1) and (5) being preferred.

The shape of the bumps 14 may be generally spherical, "Hershey-kiss"-shaped, or any other suitable shape. The bumps 14 may be formed by wire ball-bonding, plating (with or without seed layers, sacrificial layers, and/or barrier layers), or any other method known to those skilled in the microelectronics art.

Atop each copper pad 22, a layer of silver 30 is deposited. The silver layer 30 may be deposited by electroless, electrolytic, or immersion plating, with immersion plating being the preferred approach. Applicants have found that only a very thin layer of silver is needed, on the order of 2 to 10 microinches, with about 3 to 8 microinches being preferred. This thickness of immersion silver coating is easily, quickly, and inexpensively applied, especially in comparison with the prior art approach of plating successive, thick layers of nickel and gold atop the copper pads.

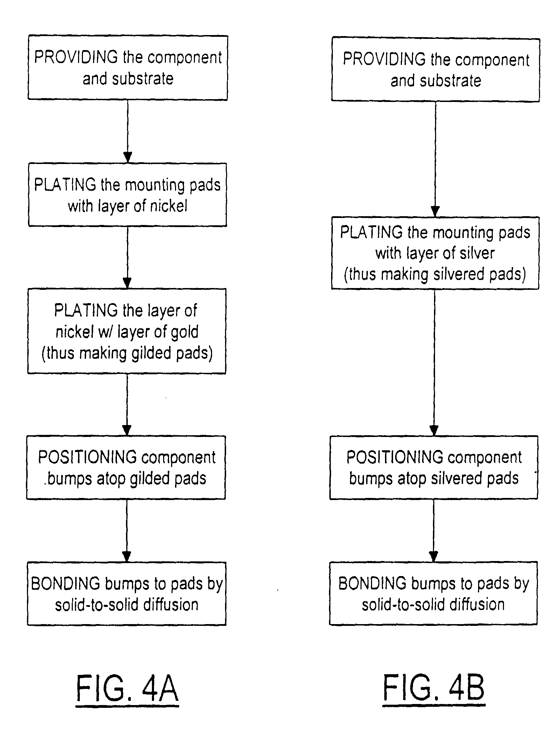

The method for bonding the gold-bumped component 10 to the substrate 20 is illustrated in FIG. 4B, which may be compared with the prior art approach shown in FIG. 4A. First, the component 10 and substrate 20 are provided. Second, a layer of silver is deposited atop each copper mounting pad 22, such as by immersion plating, thereby forming a plurality of silvered pads 40. Third, the component 10 is positioned atop the substrate 20 such that each bump termination 14 is registered atop a respective one of the silvered pads 40. And fourth, the bump terminations 14 are bonded to their respective silvered pads 40 by solid-to-solid diffusion bonding, such as by thermocompression bonding, thermosonic bonding, or ultrasonic bonding.

Testing of the present invention method was conducted using an IC with 112 gold-bumped interconnects and a standard FR-4 epoxy-glass laminate substrate with 35-micron-thick (i.e., 1-ounce) copper mounting pads immersion plated with a 3-microinch-thick layer of silver. The substrate and IC were heated to 75°C and 325°C, respectively, then the IC was placed on the substrate with each gold bump registered atop its respective silvered mounting pad, and then a compression force of 36 kg was exerted on the IC/substrate for 30 seconds. The bonded assembly was then tested for mechanical and electrical connection integrity and found to be as acceptable as conventional assemblies which rely on traditional gold-to-gold contact.

Various other modifications to the present invention may occur to those skilled in the art to which the present invention pertains. For example, it may be desired to provide an organic antioxidant layer 32 atop each silvered pad 40, as illustrated-in FIG. 5. This layer 32 may be provided by applying a coating atop the silvered pads 40 after the silver depositing step, or may be provided by mixing the antioxidant in the silver solution before the depositing step. For example, such antioxidants as benzimidazole, imidazole, or benzotriozole may be mixed into an immersion silver solution of silver nitrate, or may be applied atop the silver layer 30 after plating. In either case, the antioxidant layer 32 may be as little as 1 microinch in thickness. Also, it should be understood that when particular metals are mentioned herein, alloys containing such metals are also included.

## Claims

1. A method for bonding an electronic component (10) having bump terminations (14) on a surface thereof to a dielectric substrate (20) having a plurality of copper mounting pads (22) arranged thereon in matched relation with the bump terminations of the electronic component, comprising the steps of:
(a) providing the component (10) and the substrate (20);
(b) depositing a layer (30) of silver atop each copper mounting pad (22), thereby forming a plurality of silvered pads (40);
(c) positioning the component (10) atop the substrate (20) such that each bump termination (14) is registered atop a respective one of the silvered pads (40); and
(d) bonding the bump terminations (14) to their respective silvered pads (40) by solid-to-solid diffusion bonding.

2. A method according to claim 1, wherein said depositing step comprises electroless plating, electrolytic plating, or immersion plating.

3. A method according to claim 1 or 2, wherein each layer of silver is generally between 2 and 10 microinches thick.

4. A method according to any one of claims 1 to 3, wherein the bump terminations have an outer surface made of noble metal.

5. A method according to any one of the preceding claims, wherein the electronic component is a silicon integrated circuit bare die.

6. A method according to any one of the preceding claims, wherein said bonding step comprises thermocompression, thermosonic bonding, or ultrasonic bonding.

7. A method according to any one of the preceding claims, further comprising the step of coating the silvered pads with an organic antioxidant after said depositing step.

8. A method according to any one of the preceding claims, wherein said depositing step comprises plating the copper pads in a mixture of ionic silver solution and organic antioxidant, thereby forming a plurality of silvered pads having an outer layer of antioxidant thereon.
